# DEMANDE DE BREVET EUROPEEN

(11) **EP 1 128 588 A1**
(43) Date de publication de la demande: **29.08.2001**
(21) Numéro de dépôt: 01400355.2
(22) Date de dépôt: 12.02.2001
(51) Int. Cl.: H04L 1/00

(54) **Procédé de transmission numérique de type à codage correcteur d'erreurs comprenant une étape de sélection de schéma de poinçonnage**

(30) Priorité: 23.02.2000 FR 0002579
(71) Demandeur: Mitsubishi Electric Information Technology Centre Europe B.V., 1101 AG Amsterdam Zuidoost (NL)
(72) Inventeur: Mottier, David, 35700 Rennes (FR); Gueguen, Arnaud, 35700 Rennes (FR)
(74) Mandataire: Maillet, Alain

(57) **Abrégé**

La présente invention concerne un procédé de transmission numérique de type à codage correcteur d'erreurs qui comprend, avant une étape de transmission sur un canal, une procédure de codage comprenant au moins une étape de poinçonnage, et, après ladite étape de transmission, une procédure de décodage comprenant au moins une étape de dépoinçonnage, ladite procédure de codage, appliquant un schéma de codage donné, générant une information codée représentative avec une certaine redondance de ladite information utile et ladite procédure de décodage estimant ladite information utile en corrigeant des erreurs de transmission. Selon l'invention, ce procédé de transmission numérique comprend en outre une étape d'observation des conditions de transmission et une étape (2) de sélection de schéma de poinçonnage pour sélectionner en fonction dudit au moins un paramètre un schéma de poinçonnage de performance optimale parmi une pluralité de schéma de poinçonnage prédéterminés, le rendement global de ladite étape de codage et de ladite étape de poinçonnage étant un rendement constant. Le procédé comprend également une étape (3) d'adaptation de schéma de codage qui vérifie si ledit schéma de poinçonnage sélectionné par ladite étape (2) de sélection de schéma de poinçonnage conduit au poinçonnage intégral d'au moins une information de sortie d'une étape de codage, parmi une pluralité d'étapes de codage dont l'association en parallèle forme ledit schéma de codage, et qui, le cas échéant, modifie ledit schéma de codage de sorte que ladite étape de codage n'est plus utilisée.

## Description

La présente invention concerne de manière générale un procédé de transmission numérique de type à codage correcteur d'erreurs, notamment pour un système de transmission numérique sur canal à perturbation importante. Plus précisément, elle concerne une amélioration d'un procédé de transmission numérique, de type à codage correcteur d'erreurs utilisant des schémas de codage de type codes convolutifs et turbo-codes à concaténation parallèle, permettant une adaptation aux conditions de transmission.

Un système de transmission numérique véhicule de l'information en utilisant un support physique comme le câble, la fibre optique ou la propagation sur un canal radioélectrique satellitaire ou non. On désignera un tel support physique par le terme canal. Généralement, un tel système comprend notamment, au niveau de l'émission, un dispositif codeur de canal et, au niveau de la réception, un dispositif décodeur.

Le dispositif codeur de canal a une fonction dite de codage correcteur d'erreurs. La fonction de codage correcteur d'erreurs consiste à générer, pour une information utile, une information redondante, qui, lors du décodage au niveau de la destination, va permettre de reconstituer l'information utile à partir de l'information arrivant à destination entachée par les perturbations intervenant sur le canal, notamment de type bruit, atténuations et interférences. Un procédé de transmission numérique utilisant un tel codage canal associé à un décodage correspondant de destination est appelé procédé de transmission de type à codage correcteur d'erreurs.

La qualité d'un système de transmission numérique est évaluée, en général, en calculant la probabilité d'erreur par bit transmis. Cette dernière est notamment fonction du rapport signal sur bruit de la liaison. Le codage correcteur d'erreur, associé au décodage correspondant, vise à améliorer la qualité de la transmission grâce à la redondance introduite dans le signal. Des informations redondantes ayant été introduites par le dispositif codeur, le dispositif décodeur va utiliser les informations redondantes reçues et sa connaissance de la loi de codage pour corriger les erreurs éventuelles. Autrement dit, au niveau de la destination, à partir de l'information reçue endommagée par le canal, est reconstituée l'information utile correspondante. Par exemple, du fait de la redondance, seules certaines séquences d'information codée, conformes à la loi de codage, sont possibles. Si des séquences d'information reçue à décoder sont différentes de ces séquences possibles, c'est qu'elles correspondent à de l'information détériorée par le canal. Dans le cas d'un décodage à maximum de vraisemblance, le procédé de décodage va reconstituer l'information utile en déterminant, à partir de la séquence d'information reçue et en considérant les différentes séquences permises, la séquence d'information utile la plus vraisemblable.

Plus la capacité de discrimination entre les séquences que permet l'ensemble des opérations de codage et décodage est importante, plus la capacité de correction d'erreurs est importante. Une conséquence importante de la redondance introduite par le codage est l'accroissement du débit numérique. Un paramètre important du codeur est donc son rendement qui est égal au nombre de bits d'information par bit transmis. En général plus le rendement est faible, plus le code est robuste.

La performance d'une transmission à codage correcteur d'erreurs se mesure généralement en terme de taux d'erreurs binaires ou paquets pour un rapport E_{b}/Nₒ donné, où E_{b} est l'énergie par bit d'information et Nₒ est la densité spectrale de puissance du bruit. On qualifie de plus ou moins performant un code selon que son emploi permet un taux d'erreurs plus ou moins faible pour un rapport E_{b}/Nₒ donné et pour une complexité de décodage donnée.

Il est possible d'améliorer la performance en utilisant un code de plus faible rendement. Cependant, cela se fait au détriment de l'efficacité spectrale de la transmission. Généralement, le rendement utilisé est le rendement permettant de garantir un taux d'erreur prédéterminé, ce rendement pouvant éventuellement évoluer suivant les conditions de transmission.

Des codes correcteurs d'erreurs connus sont les codes en bloc. Le codage en bloc consiste à associer à chaque bloc de k bits d'information un bloc de n bits (n>k) contenant donc (n-k) bits de redondance. Le bloc de n bits est obtenu en multipliant le bloc de k bits utile par une matrice à k lignes et n colonnes appelée matrice génératrice du code. Lorsque, par permutation, la matrice génératrice est écrite sous une forme telle qu'elle fait apparaître la matrice identité, de sorte que, dans le bloc de n bits, les k bits d'information et les n-k bits de redondance sont séparés, le code est dit systématique. Le rendement du code est égal à k/n. Le dispositif décodeur détecte les erreurs et les corrige par l'intermédiaire de la distance de Hamming minimale. De tels codes détecteurs d'erreurs bien connus dans la technique sont par exemple les codes de Hamming, les codes BCH et les codes de Reed-Solomon.

Est également bien connu le fait d'effectuer un codage correcteur d'erreurs à l'aide d'un ou plusieurs codeurs convolutifs. Leur principe de fonctionnement consiste à coder un bloc de k éléments binaires présents à l'entrée du codeur en un bloc de n éléments binaires en tenant compte également de m blocs précédents le bloc présent en entrée, à l'aide d'un dispositif à registre. La sortie du codeur convolutif est constituée de n éléments binaires codés générés par le produit de convolution des k éléments binaires présents à l'entrée avec la réponse du codeur définie par n polynômes générateurs. Le nombre n de polynômes générateurs du codeur est appelé dimension du codeur. Le rendement du code est égal à k/n. Le dispositif décodeur reconstruit les données d'origine par exemple à l'aide d'un décodage de type séquentiel, un décodage suivant le symbole le plus vraisemblable, ou un décodage suivant la séquence la plus vraisemblable, ainsi que décrit, par exemple, dans le document « Digital Communications », par J.G. Proakis, paru en 1995 aux éditions MacGraw-Hill. Par exemple, l'algorithme de Viterbi assure un décodage optimal suivant la séquence la plus vraisemblable.

Selon une variante de ce type de codes, le codage ne se fait pas en prenant directement en compte une série de m informations utiles précédant l'information à coder, mais en utilisant une série de m informations auxiliaires, mémorisées dans un dispositif de type registre à décalage obtenues chacune par combinaison mathématique d'une information utile et de m informations auxiliaires calculées précédemment. Un tel code convolutif est dit récursif Lorsque, en outre, l'information utile ressort telle quelle parmi les n sorties du codeur au côté de (n-1) informations codées ou informations redondantes, le code résultant est appelé code convolutif récursif systématique, ou code RSC.

Est également connu le fait d'associer différents codeurs afin d'augmenter la performance du codage. Par exemple, les données codées par un premier codeur peuvent alimenter un second codeur. Le décodage se fait symétriquement, en commençant par le second code.

Un type performant d'association de codeurs a été proposé, ainsi que décrit notamment dans le document « Near Shannon Limit Error - Correcting Coding and Decoding : Turbo-codes », par C. Berrou, A. Glavieux, P. Thitimajshima, paru dans ICC-1993, Conference Proceedings aux pages 1064-1070. Ce type d'association de codeurs a donné naissance a une famille de schémas de codage connue dans la technique sous le nom de turbo-codes. L'on désignera par turbo-codes les codes correcteurs d'erreurs basés sur l'association, appelée concaténation, de plusieurs codes simples, appelés codes élémentaires, avec intervention d'opérations de permutation, appelées entrelacements qui modifient l'ordre de prise en compte des données par chacun des codes simples. Par codes élémentaires, on entend des codes introduisant une redondance, du type décrit plus haut. Il peut s'agir, par exemple, de codes convolutifs récursifs systématiques pour les turbo-codes convolutifs, des codes en bloc de Hamming ou BCH pour les turbo-codes en bloc. Différents types de concaténation peuvent être envisagés. Dans la concaténation parallèle, la même information est codée par chaque codeur séparément après avoir été entrelacée. Dans la concaténation série, la sortie de chaque codeur est codée par le codeur suivant après avoir été entrelacée. On appelle dimension du turbo-code le nombre de codeurs élémentaires utilisés pour mettre en oeuvre ce turbo-code. Un schéma de turbo-codage bien connu consiste en une concaténation parallèle de codes élémentaires de type Code Convolutif Récursif Systématique (RSC). On désigne ce turbo-code par le terme PCCC. Des exemples de turbo-codes à concaténation série sont les SCCC qui utilisent des codes élémentaires de type codes convolutifs et les turbo-codes en bloc qui utilisent des codes élémentaires de type codes en bloc.

Une information codée par un turbo-code peut être décodée par un procédé itératif appelé turbo-décodage. Sont associés plusieurs décodeurs élémentaires à entrées et sorties pondérées correspondant chacun à un codeur élémentaire du dispositif de codage. Les entrées et sorties pondérées se font en termes de probabilités, de rapports de vraisemblance, ou de logarithmes de rapports de vraisemblance. Des entrelaceurs et désentrelaceurs permettent à chaque décodeur de prendre en compte une information qui se présente dans le même ordre que celle en sortie et en entrée du codeur correspondant. Chaque décodeur élémentaire utilise la partie de l'information reçue associée au codeur correspondant ainsi qu'une estimation d'une partie ou de toute cette information obtenue par un ou plusieurs décodeurs élémentaires précédents pour générer une estimation de fiabilité accrue de cette même information. L'information supplémentaire générée par un décodeur élémentaire est appelée information extrinsèque .Elle est utilisée par un ou plusieurs décodeurs élémentaires suivants après entrelacement ou désentrelacement adapté. L'échange d'information extrinsèque se fait entre décodeurs élémentaires au sein d'une même étape, et de cette étape vers l'étape suivante. Chaque nouvelle étape accroît donc la fiabilité de l'information générée en sortie. Les décodeurs élémentaires utilisent par exemple les algorithmes MAP, LogMAP, MaxLogMAP, SOVA, Chase, qui sont décrits, par exemple, dans les articles « Optimal and sub-optimal maximum a posteriori algorithms suitable for turbo decoding » de P. Robertson, P. Hoeher, E. Villebrun, paru dans European Trans. on Telecommun., vol. 8, mars-avril 1997, aux pages 119-125 et « A very low complexity block turbo decoder for product codes » de R. Pyndiah, P. Combelles, P. Adde, paru dans Proc., IEEE Globecom 1996, aux pages 101-105. Un seuillage est appliqué sur l'information en sortie de la dernière étape de décodage pour générer l'information décodée.

Est également connu le fait que le rendement d'un code peut être augmenté par une opération de poinçonnage qui consiste à ne pas transmettre certains bits d'une séquence d'information, ainsi qu'il est décrit, par exemple, dans l'article « Rate-Compatible Punctured Convolutional (RCPC) codes and their application», par J. Hagenauer, paru dans IEEE Trans., Vol COM-36.4, 1988, aux pages 389-400 ou dans l'article « New Rate Compatible Punctured Convolutional Codes for Viterbi decoding », par L.H.C. Lee, paru dans IEEE Trans., Vol. COM-42.2, 1994, aux pages 3073-3079. Ces bits non transmis sont en général des bits d'information redondante. Cette opération de poinçonnage intervient au niveau de l'émission, après l'opération de codage. Au niveau de la destination, une opération réciproque de dépoinçonnage est effectuée avant l'opération de décodage. Les opérations de poinçonnage et de dépoinçonnage sont définies par une même matrice ou schéma de poinçonnage. Le poinçonnage de bits d'information redondante diminue la capacité de correction du code et augmente son rendement.

Les codes correcteurs d'erreurs selon l'état de la technique décrit plus haut, et notamment les codes correcteurs d'erreurs de la famille des turbo-codes, permettent d'obtenir une correction d'erreurs très performante tout en conservant des rendements suffisamment importants et en permettant des opérations de décodage à faible complexité au regard de la complexité du code.

Cependant, l'on sait que les performances d'une transmission utilisant un code correcteur d'erreurs varient selon les conditions de transmission. On entend par conditions de transmission les paramètres influant sur les performances de la transmission comme notamment le rapport signal sur bruit, mais également le taux d'erreurs binaires ou paquets, le rapport signal sur interférence plus bruit, le nombre d'utilisateurs actifs d'un système de télécommunications, la qualité de service requise par le système de transmission, la vitesse de déplacement de l'utilisateur du système de transmission ou tout autre paramètre.

Dans l'état de la technique, l'adaptation aux conditions de transmission se fait en diminuant ou augmentant le rendement afin de rendre le code plus ou moins robuste suivant que le canal est plus ou moins sévère. Pour ne pas avoir à modifier la structure du codeur, un poinçonnage est réalisé. A chaque rendement correspond un unique schéma de poinçonnage.

Cependant, les différents codes présentent des performances inhomogène, lorsqu'on les compare à rendement égal, en fonction des conditions de transmission. Ainsi, par exemple, un PCCC à deux dimensions présente des performances excellentes à bas rapport signal/bruit, le taux d'erreur pouvant alors être inférieur, à rendement identique, à celui engendré par l'utilisation d'un turbo-codeur de dimension supérieure. Plus généralement, l'on a mis en évidence que, lorsque l'on utilise un turbo-code convolutif, les courbes de taux d'erreurs binaires en fonction du rapport signal/bruit, si elles décroissent très rapidement au delà d'un point caractéristique que l'on désignera par le terme point d'avalanche, restent, en deçà de ce point, dans des zones de performances inférieures à celles correspondant à des codes convolutifs équivalents, c'est-à-dire de même rendement.

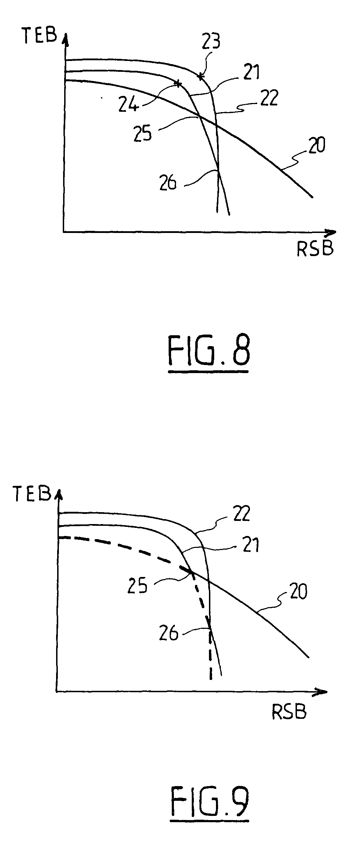

Dans le cadre de la présente invention, l'on a de manière systématique comparé les performances de différents codes convolutifs et turbo-codes à rendement constant. La Fig. 8 présente un exemple de cette étude sous forme de courbes de performance donnant le taux d'erreurs binaires en fonction du rapport signal sur bruit. La courbe de performance 20 est caractéristique de l'utilisation d'un code convolutif, tandis que les courbes de performances 21 et 22 sont caractéristiques de l'utilisation de turbo-codes convolutifs de dimensions respectives 2 et 3 qui utilisent comme codes élémentaires le même code convolutif que celui de la courbe 20. Des schémas de poinçonnage différents ont été appliqués pour ces trois codes de manière à ce que leurs rendements soient égaux. L'on a ainsi mis en évidence que, à rendement de codage donné, plus la dimension des turbo-codes est importante, plus il faut atteindre un rapport signal sur bruit élevé pour atteindre l'effet d'avalanche qui suit le point d'avalanche. En deçà, leurs performances sont inférieures à celles d'un turbo-code de dimension inférieure, au delà, elles deviennent rapidement supérieures. Ainsi, dans la Fig. 8, le point d'avalanche 23 propre au turbo-code de dimension 3 correspond à un rapport signal/bruit supérieur à celui du point d'avalanche 24 propre au turbo-code de dimension 2. En deçà d'un point d'intersection 26 se trouvant légèrement après le point d'avalanche 23, le turbo-code de dimension 3 est moins performant que le turbo-code de dimension 2. Au delà, il est plus performant. En deçà d'un point d'intersection 25, le code convolutif est plus performant que le turbo-code de dimension 2. Au delà, il est moins performant.

De manière encore plus générale, l'on a mis en évidence le fait que, pour tous les codes à n dimensions, tels les codes convolutifs, où la dimension n est égale au nombre de polynômes générateurs, et les turbo-codes, où la dimension n est égale au nombre de codeurs élémentaires, dont le rendement sans poinçonnage est de Rₘ, il existe, pour un rendement donné R_{c} > Rₘ, une répartition optimale de la redondance pour des conditions de transmission données.

Un objet de la présente invention est donc d'adapter un procédé de transmission de type à codage correcteur d'erreurs en fonction des conditions de transmission en modifiant la répartition de l'information redondante à rendement constant.

A cet effet, elle propose un procédé de transmission numérique de type à codage correcteur d'erreurs, comprenant, avant une étape de transmission sur un canal, une procédure de codage, appliquant un schéma de codage donné pour générer, à partir d'une information utile, une information codée avec une certaine redondance, et comprenant au moins une étape de poinçonnage appliquant un schéma de poinçonnage donné, et, après ladite étape de transmission sur ledit canal, une procédure de décodage, appliquant un schéma de décodage donné, pour obtenir, à partir d'une information à décoder, une estimation de ladite information utile en corrigeant des erreurs de transmission à l'aide de ladite certaine redondance, et comprenant au moins une étape de dépoinçonnage appliquant un schéma de dépoinçonnage donné, ledit procédé de transmission étant caractérisé en ce qu'il comprend en outre une étape d'analyse des conditions de transmission pour déterminer au moins un paramètre caractéristique des conditions de transmission, une étape de sélection de schéma de poinçonnage pour sélectionner en fonction dudit au moins un paramètre un schéma de poinçonnage de performance optimale parmi une pluralité de schémas de poinçonnage prédéterminés, une étape de sélection de schéma de dépoinçonnage pour sélectionner en fonction dudit au moins un paramètre un schéma de dépoinçonnage correspondant audit schéma de poinçonnage de performance optimale parmi une pluralité de schémas de dépoinçonnage prédéterminés, le rendement global de ladite procédure de codage associée à ladite au moins une étape de poinçonnage étant un rendement constant.

Ainsi, en fixant un rendement cible R_{c} supérieur au rendement du schéma de codage initial Rₘ, la répartition du poinçonnage est ajustée dynamiquement au cours du temps suivant les conditions de transmission afin de garantir les meilleures performances. Ainsi qu'il a été dit précédemment, le ou les paramètres caractéristiques des conditions de transmission peuvent être le taux d'erreurs binaires, le taux d'erreurs paquets, le rapport signal/bruit, le rapport signal sur interférence plus bruit, le nombre d'utilisateurs actifs d'un système de télécommunication, la qualité de service requise par le système de transmission, la vitesse de déplacement de l'utilisateur du système de transmission ou tout autre paramètre susceptible d'influer sur les performances du système de transmission. Ce ou ces paramètres peuvent être directement évalués au niveau de l'émission, par exemple, à partir de mesures faites sur les signaux transmis. Ils peuvent aussi être fournis par un signal de contrôle externe. La pluralité de schémas de poinçonnage est prédéterminée en fonction d'une étude préalable des performances du codage en fonction des conditions de transmission permettant de déterminer, pour chaque condition de transmission, le schéma de poinçonnage conduisant aux meilleures performances. Notamment, deux schémas de poinçonnage peuvent se distinguer par le fait que les informations codées élémentaires d'une ou plusieurs étapes de codage élémentaire sont intégralement poinçonnées en appliquant l'un alors qu'elles ne le sont pas en appliquant l'autre. De la sorte, si l'on prend par exemple le cas des turbo-codes, le changement de schéma de poinçonnage peut être équivalent à un changement de dimension du turbo-code. Par exemple, si l'on se réfère aux courbes de performances de la Fig. 8, l'on peut, sur la base d'un turbo-code de dimension 3, prédéfinir trois schémas de poinçonnage dont les combinaisons respectives avec le schéma de codage permettent d'obtenir trois équivalences de turbo-codage de dimensions respectivement 1, 2 et 3 ayant le même rendement. Le turbo-code de dimension 1 correspond à un code convolutif. En fonctionnement, l'on sélectionne le schéma de poinçonnage tel que l'opération équivalente de l'opération de codage et de l'opération de poinçonnage est un codage convolutif lorsque le rapport signal sur bruit est inférieur au point d'intersection 25 entre la courbe 20 et la courbe 21, l'on sélectionne le schéma de poinçonnage tel que cette opération équivalente est un turbo-codage de dimension 2 lorsque ce rapport signal sur bruit est compris entre ce point d'intersection 25 et le point d'intersection 26 entre la courbe 21 et la courbe 22, et l'on sélectionne le reste du temps le schéma de poinçonnage n'entraînant aucun poinçonnage intégral. L'on dispose ainsi d'un codage à rendement constant à courbe de performance optimale représentée en traits interrompus sur la Fig. 9. Les schémas de poinçonnage correspondant aux différentes conditions de transmission peuvent être mémorisés dans une table de correspondance.

Selon un autre aspect de la présente invention, ladite procédure de codage comprenant une pluralité d'étapes de codage élémentaire, associéesen parallèle, chacune desdites étapes de codage élémentaire générant une information codée élémentaire, il comprend également une étape d'adaptation de schéma de codage qui vérifie si ledit schéma de poinçonnage sélectionné par ladite étape de sélection de schéma de poinçonnage conduit au poinçonnage intégral de l'information codée élémentaire d'une desdites étapes de codage élémentaire et qui, le cas échéant, modifie ledit schéma de codage de manière à ne plus avoir à utiliser ladite au moins une desdites étapes de codage élémentaire.

Selon un autre aspect de la présente invention, ladite procédure de codage applique un schéma de codage de type codage convolutif, lesdites étapes de codage élémentaire étant associées en parallèle et générant chacune une information codée élémentaire issue du produit de convolution d'une séquence constituée par ladite information utile et par un certain nombre d'informations auxiliaires, pouvant correspondre à des informations utiles précédentes, avec une réponse définie par un polynôme générateur.

Selon un autre aspect de la présente invention, ladite procédure de codage applique un schéma de codage de type turbo-codage, lesdites étapes de codage élémentaire étant concaténées en parallèle, en association avec des étapes d'entrelacement adaptées et une étape de poinçonnage intervenant après une étape de multiplexage associant les informations codées élémentaires desdites étapes de codage élémentaire.

Selon un autre aspect de la présente invention, ladite procédure de décodage comprenant une pluralité d'étapes de décodage élémentaire correspondant respectivement auxdites étapes de codage élémentaire, chacune desdites étapes de décodage élémentaire traitant une information à décoder correspondant à ladite information codée élémentaire de l'étape de codage élémentaire correspondante, il comprend également une étape d'adaptation de schéma de décodage qui vérifie si ledit schéma de dépoinçonnage sélectionné par ladite étape de sélection de schéma de dépoinçonnage indique qu'au moins une desdites étapes de décodage élémentaire correspond à une étape de codage élémentaire dont l'information codée élémentaire est intégralement poinçonnée et qui, le cas échéant, modifie ledit schéma de décodage de manière à ne plus avoir à utiliser ladite au moins une desdites étapes de décodage élémentaire.

Cette étape d'adaptation de schéma de décodage ainsi définie peut convenir à un turbo-code parallèle.

Selon un autre aspect de la présente invention, ladite procédure de décodage reconstituant l'information utile à partir de n informations à décoder correspondant à n informations codées représentatives de l'information utile issues desdites étapes de codage élémentaire, il comprend également une étape d'adaptation de schéma de décodage qui vérifie si ledit schéma de dépoinçonnage sélectionné par ladite étape de sélection de schéma de dépoinçonnage indique qu'au moins une desdites informations codées a été intégralement poinçonnée et qui, le cas échéant, modifie ledit schéma de décodage de manière à ne plus tenir compte de l'information à décoder correspondant à ladite au moins une desdites informations codées.

Cette étape d'adaptation de schéma de décodage ainsi définie est particulièrement adaptée pour les codes convolutifs.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1 est un organigramme illustrant le principe de base d'une étape de sélection de schéma de poinçonnage d'un procédé de transmission selon la présente invention ;
la Fig. 2 est un organigramme illustrant le principe de base d'une étape d'adaptation de schéma de codage d'un procédé de transmission selon la présente invention ;
la Fig. 3 est un organigramme illustrant le principe de base d'une étape de sélection de schéma de dépoinçonnage d'un procédé de transmission selon la présente invention ;
la Fig. 4 est un organigramme illustrant le principe de base d'une étape d'adaptation de schéma de décodage d'un procédé de transmission selon la présente invention ;
la Fig. 5 est un schéma illustrant un codeur convolutif à trois dimensions ;
la Fig. 6 est un schéma illustrant un turbo-codeur parallèle à n dimensions ;
la Fig. 7 est un schéma illustrant un PCCC à deux dimensions ;
la Fig. 8 est un graphe montrant des courbes de performances de turbo codes à différentes dimensions ; et
la Fig. 9 est un graphe montrant une courbe de performance optimale d'un turbo-code à trois dimensions auquel s'applique un poinçonnage dynamique selon la présente invention.

Globalement, dans un procédé de transmission numérique de type à codage correcteur d'erreurs, la présente invention permet, en maintenant constant le rendement global, c'est-à-dire le rendement tenant compte de l'opération de poinçonnage, égal à un rendement cible R_{c} prédéterminé supérieur au rendement Rₘ du codage, de sélectionner en fonction des conditions de transmission un schéma de poinçonnage parmi des schémas de poinçonnage prédéterminés, de telle sorte que les performances du procédé de transmission numérique à codage correcteur d'erreurs soient optimales pour ces conditions de transmission.

Les modes de réalisation de la présente invention décrits s'appliquent à un procédé de transmission de type à codage correcteur d'erreurs dans lequel, au niveau de l'émission, une procédure de codage comprend n étapes de codage élémentaire générant chacune une information codée élémentaire. Il peut s'agir notamment d'un procédé de turbo-codage à concaténation parallèle. Il peut s'agir également d'un code convolutif, les n étapes de codage élémentaires étant alors définies par les n polynômes générateurs du code convolutif. Au niveau de la destination, une procédure de décodage reconstitue l'information à l'aide de n étapes de décodage élémentaire correspondant aux n étapes de codage élémentaire ou bien de n informations à décoder correspondant aux informations codées par les n étapes de codage élémentaire dans le cas du code convolutif. Plus précisément, dans ce dernier cas, les n informations à décoder correspondent aux n informations codées poinçonnées, transmises sur le canal et dépoinçonnées.

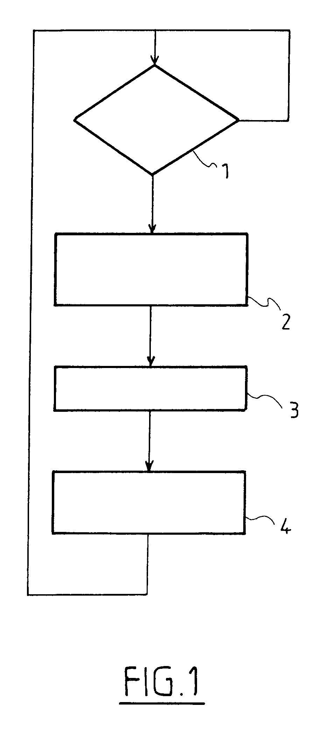

La Fig. 1 présente un traitement de sélection de schéma de poinçonnage et de codage selon la présente invention. Un bloc de décision 1 détermine si les conditions de transmission sont ou non modifiées. Il se base pour cela sur un traitement parallèle (non représenté) d'observation des conditions de transmission qui analyse en permanence les conditions de transmission. Ce traitement se fonde, par exemple sur un paramètre tel que le rapport signal sur bruit qu'il mesure en permanence. Lorsque ce paramètre passe d'un état à un autre, le bloc de décision 1 fait passer le traitement à une étape 2. Dans l'étape 2, un schéma de poinçonnage est sélectionné en fonction du ou des paramètres mesurés par le traitement d'observation des conditions de transmission. La sélection est effectuée parmi une pluralité de schémas de poinçonnage prédéterminés pour le rendement cible R_{c}. Ces schémas sont, par exemple, mémorisés dans une table de correspondance. Chacun de ces schémas de poinçonnage correspond, pour une condition de transmission donnée, à un schéma de poinçonnage optimum, c'est-à-dire celui dont l'association avec le schéma de codage conduit aux meilleures performances de transmission. Ces performances sont mesurées, par exemple en terme de taux d'erreurs binaires. De la sorte, pour chaque condition de transmission donnée, l'étape 2 sélectionne le schéma de poinçonnage optimum, sans modification du rendement cible R_{c}.

Une étape 3, préalable à l'application du schéma de poinçonnage déterminé par l'étape 2, va vérifier si l'application de ce schéma de poinçonnage conduit au poinçonnage total d'information codée élémentaire d'une ou plusieurs étapes de codage élémentaire et modifier le schéma de codage en conséquence.

Une étape 4, enfin, va appliquer le nouveau schéma de codage et le nouveau schéma de poinçonnage déterminés par les étapes précédentes.

Le traitement retourne ensuite au bloc de décision 1 et y reste tant qu'il n'y a pas de nouvelle modification des conditions de transmission.

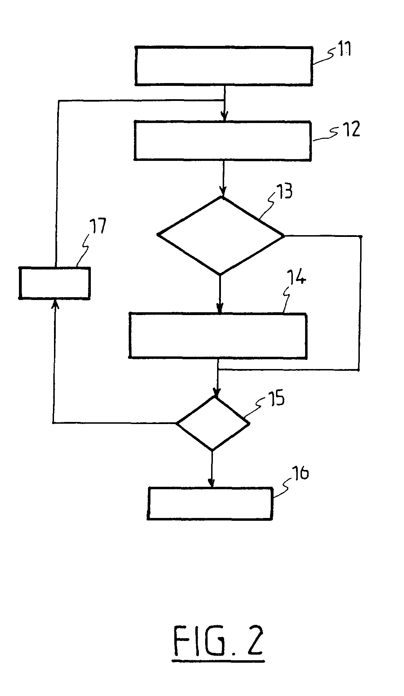

La Fig. 2 décrit de manière plus précise le traitement effectué à l'étape 3.

Au niveau d'une étape 11, une variable i est initialisée à 1. Cette variable i est incrémentée au niveau d'une étape 17 de manière à pouvoir analyser l'effet du poinçonnage sur chacune des informations codées élémentaires des n étapes de codage. Au niveau d'une étape 12, le traitement analyse le poinçonnage appliqué à l'information codée générée par la i^{ème} étape de codage élémentaire suivant le schéma de poinçonnage sélectionné au niveau de l'étape 2. Si le poinçonnage appliqué à l'information codée élémentaire générée par la i^{ème} étape de codage élémentaire est intégral, le bloc de décision 13 fait passer le traitement à l'étape 14. Sinon, le traitement passe directement à l'étape 15. A l'étape 14, le schéma de codage est modifié afin que la i^{ème} étape de codage élémentaire soit désactivée. Au niveau du bloc de décision 15, il est déterminé si i est ou non inférieur à n. Si oui, le traitement retourne à l'étape 12 en passant par l'étape 17 où i est incrémenté. Sinon, le traitement passe à l'étape 16 qui clôt l'étape 3.

Le traitement mis en oeuvre au niveau de l'émission requiert, au niveau de la destination, une opération de dépoinçonnage et décodage spécifique établie sur les bases de l'opération de décodage correspondant au codage utilisé et prenant en compte les différents schémas de poinçonnage sélectionnés au niveau de l'émission. Par exemple, on peut reconstituer avant décodage la séquence codée de rendement égal au rendement de codage en insérant un bit de fiabilité nulle, c'est-à-dire une valeur ne portant aucune information sur le bit correspondant, à l'endroit où un bit a été poinçonné. Des simplifications sont possibles au niveau du décodage si des informations codées élémentaires d'une ou plusieurs étapes de codage élémentaire ont été entièrement poinçonnées à l'émission.

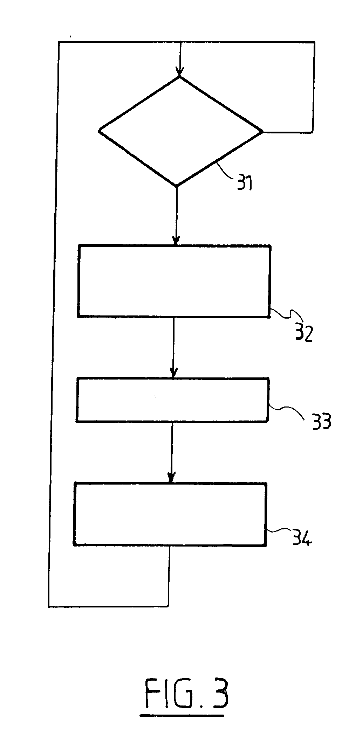

La Fig. 3 présente un traitement de sélection de schéma de dépoinçonnage et de schéma de décodage selon la présente invention. Un bloc de décision 31 détermine si les conditions de transmission sont ou non modifiées. Il se base pour cela sur un traitement parallèle (non représenté) d'observation des conditions de transmission qui analyse en permanence les conditions de transmission. Ce traitement se fonde, par exemple sur un paramètre tel que le rapport signal sur bruit qu'il mesure en permanence. Lorsque ce paramètre passe d'un état à un autre, le bloc de décision 31 fait passer le traitement à une étape 32. Dans l'étape 32, un schéma de dépoinçonnage est sélectionné en fonction du ou des paramètres mesurés par le traitement d'observation des conditions de transmission. La sélection est effectuée parmi une pluralité de schémas de dépoinçonnage prédéterminés pour le rendement cible R_{c}., et correspondant aux schémas de poinçonnage évoqués dans la description de la Fig. 1. Ces schémas sont, par exemple, mémorisés dans une table de correspondance. Une étape 33, préalable à l'application du schéma de dépoinçonnage déterminé par l'étape 32, va vérifier si l'application de ce schéma de dépoinçonnage permet d'ignorer une ou plusieurs des étapes de décodage élémentaire et modifier le schéma de décodage et le schéma de dépoinçonnage en conséquence.

Une étape 34, enfin, va appliquer les nouveaux schémas de dépoinçonnage et décodage tels qu'ils ressortent des étapes précédentes.

Le traitement retourne ensuite au bloc de décision 31 et y reste tant qu'il n'y a pas de nouvelle modification des conditions de transmission.

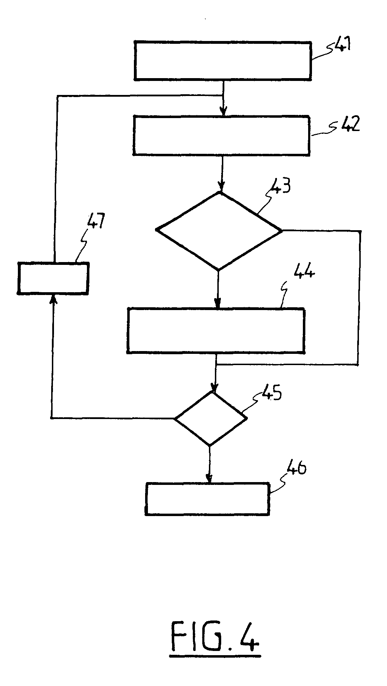

La Fig. 4 décrit de manière plus précise le traitement effectué à l'étape 33.

Au niveau d'une étape 41, une variable i est initialisée à 1. Cette variable i est incrémentée au niveau d'une étape 47 de manière à pouvoir analyser les unes après les autres chacune des n étapes de décodage élémentaire de la procédure de décodage, ou bien les n informations à décoder dans le cas d'un code convolutif. Le traitement, au niveau de l'étape 42, analyse l'information à décoder par la i^{ème} étape de décodage élémentaire, ou bien la i^{ème} information à décoder, telle qu'elle ressort du dépoinçonnage suivant le schéma de dépoinçonnage sélectionné au niveau de l'étape 32. Si la i^{ème} étape de décodage élémentaire, ou la i^{ème} information à décoder, correspond à une étape de codage élémentaire dont l'information codée est intégralement poinçonnée, ou à une information codée entièrement poinçonnée, le bloc de décision 43 fait passer le traitement à l'étape 44. Sinon, le traitement passe directement à l'étape 45. A l'étape 44, le schéma de décodage est modifié afin que la procédure de décodage n'utilise plus la i^{ème} étape de décodage élémentaire, ou la i^{ème} information à décoder, et le schéma de dépoinçonnage est modifié de manière à ce que le dépoinçonnage correspondant ne soit plus effectué. Au niveau du bloc de décision 45, il est déterminé si i est ou non inférieur à n. Si oui, le traitement retourne à l'étape 42 en passant par l'étape 47 où i est incrémenté. Sinon, le traitement passe à l'étape 46 qui clôt l'étape 33.

Selon un mode de réalisation de la présente invention, le procédé de transmission de type à codage correcteur d'erreurs peut utiliser un codage convolutif.

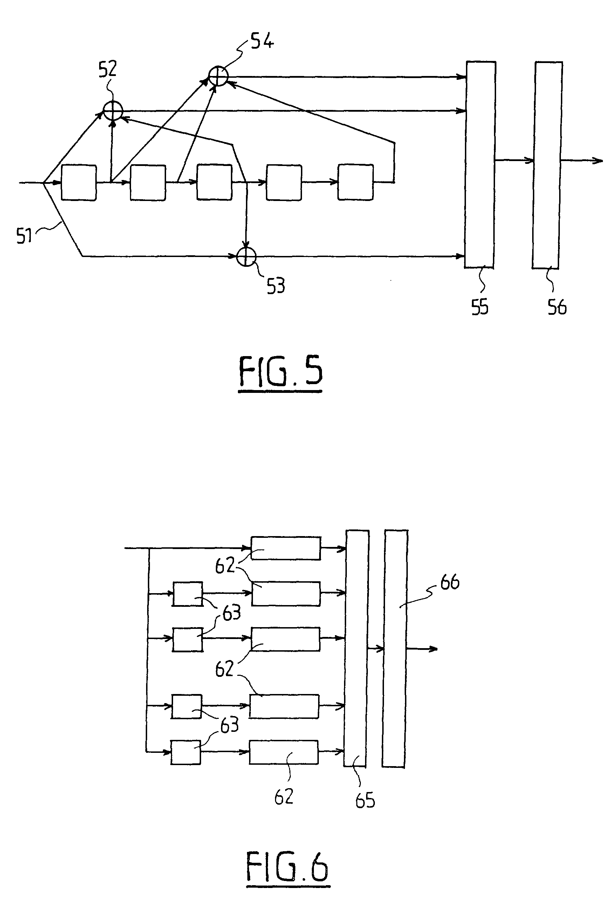

La Fig. 5 présente un codeur convolutif à trois dimensions. Les blocs d'entrée contiennent un bit (k=1). Les blocs de sortie contiennent trois bits (n=3). L'effet mémoire est de longueur 5 (m=5). Son rendement est de 1/3. Les trois informations de sortie, correspondant à trois polynômes générateurs, sont produites par une logique combinatoire, l'élément 54 définissant le premier polynôme générateur, l'élément 52 définissant le second polynôme générateur et l'élément 53 définissant le troisième polynôme générateur. Après passage dans un multiplexeur 55, les informations de sorties passent dans un poinçonneur 56. Le poinçonneur 56 est commandé grâce à un traitement de sélection de schéma de poinçonnage tel que celui décrit en référence à la Fig. 1, avec n=3. Le schéma de poinçonnage peut donc être modifié au cours de la transmission si les conditions de transmission sont modifiées. La mise en oeuvre du codage peut être simplifiée si le schéma de poinçonnage choisi conduit au poinçonnage intégral d'au moins une sortie des éléments 52, 53 et 54. Dans ce cas, la logique combinatoire associée à cette sortie est désactivée. Au niveau de la destination, le traitement de décodage est associé à un traitement de dépoinçonnage qui peut être également modifié en cours de transmission pour tenir compte des modifications des conditions de transmission. Par exemple, dans l'algorithme de Viterbi, on reconstitue avant décodage la séquence codée de rendement égal au rendement du codage en insérant un bit de fiabilité nulle à l'endroit où un bit a été poinçonné. La mise en oeuvre du décodage est simplifiée si une ou plusieurs des n informations de sortie du codeur ne sont jamais utilisées. Il n'est alors pas nécessaire de reconstituer avant décodage la séquence binaire associée à celle ou celles des n informations qui ne sont pas transmises. En d'autres termes, le décodage peut être mis en oeuvre en ne reconstituant que celles parmi les n informations à décoder qui correspondent à des informations en parties poinçonnées ou non poinçonnées.

Selon un mode de réalisation de la présente invention, le procédé de transmission de type à codage correcteur d'erreurs peut utiliser un turbo-codage à concaténation parallèle.

La Fig. 6 présente un turbo-codeur à concaténation parallèle à n dimensions 61. Il comprend n codeurs élémentaires 62. Ces codeurs 62 peuvent soit appliquer un même code élémentaire, soit des codes différents. Chaque codeur élémentaire 62 code une information d'entrée préalablement traitée par un entrelaceur correspondant 63 qui est propre audit codeur, de sorte qu'aucun desdits codeurs élémentaires 62 ne prend en compte l'information de la même manière. Les bits d'entrée sont codés par blocs de N, N étant la taille des entrelaceurs. La sortie de chacun des codeurs élémentaires passe dans un multiplexeur 65 puis dans un poinçonneur 66.

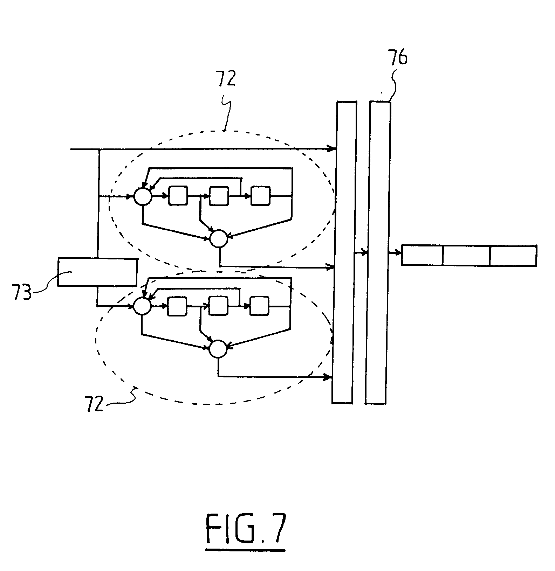

La Fig. 7 présente un exemple de PCCC à deux dimensions. Le rendement des codeurs élémentaires 72 est de ½. Cependant, la partie systématique n'est transmise qu'une fois. De la sorte, le rendement du turbo-code est de 1/3.

Le poinçonneur 66 ou 76 est commandé grâce à un traitement de sélection de schémas de poinçonnage tel que celui décrit en référence à la Fig. 1, avec n=2 dans le cas du PCCC. Le schéma de poinçonnage peut donc être modifié au cours de la transmission si les conditions de transmission varient. Si le poinçonnage requis consiste à ne plus transmettre la sortie de l'un des codeurs élémentaires, il n'est plus nécessaire d'effectuer les opérations de codage et d'entrelacement associées à cette dimension.

Par exemple, en référence aux courbes de performances de la Fig. 8, le poinçonneur 76 intervenant en aval du PCCC de la Fig. 7 peut être commandé suivant deux schémas de poinçonnage alternant au cours de la transmission en fonction des variations des conditions de transmission. Chacun de ces schémas est choisi de manière à se conformer à la courbe de performance optimale représentée sur la Fig. 9. Autrement dit, un premier de ces schémas de poinçonnage doit être tel que le poinçonnage correspondant à la sortie du second codeur élémentaire 72 soit un poinçonnage total. Le rendement global peut être alors égal au rendement d'un codeur élémentaire, c'est-à-dire un rendement de ½. L'autre de ces schémas de poinçonnage doit être tel que les sorties des deux codeurs élémentaires ne sont pas entièrement poinçonnées. Cependant, pour travailler à rendement constant, il faut que ces sorties soient poinçonnées de manière à ce que le rendement global soit de ½. Ce second schéma de poinçonnage va donc faire en sorte que la moitié des bits de redondance issus de chaque codeur élémentaire soit poinçonnée. Si l'on se réfère aux courbes de performances de la Fig. 8, le premier schéma de poinçonnage sera appliqué lorsque le rapport signal sur bruit est inférieur au point d'intersection 25 entre la courbe 20 et la courbe 21, et le second schéma de poinçonnage sera appliqué lorsque le rapport signal sur bruit est supérieur à ce point d'intersection. Lorsque le premier schéma de poinçonnage est appliqué, le second codeur élémentaire 72 et l'entrelaceur 73 sont désactivés, ce qui simplifie les opérations de codage réalisées. Bien entendu, l'on peut travailler à un autre rendement cible R_{c} supérieur au rendement Rₘ =1/3 du PCCC. Il suffit pour cela d'adapter les schémas de poinçonnage.

Le traitement de dépoinçonnage, au niveau de la destination effectue l'opération inverse du poinçonnage. Des valeurs qui ne portent aucune information sont insérées à la place des bits poinçonnés. Si la sortie d'un codeur élémentaire a été entièrement poinçonnée au niveau de la source, elle n'est pas dépoinçonnée en réception et le décodeur élémentaire correspondant à ce codeur élémentaire n'intervient pas dans le turbo-décodeur.

## Revendications

1. Procédé de transmission numérique de type à codage correcteur d'erreurs, comprenant, avant une étape de transmission sur un canal, une procédure de codage, appliquant un schéma de codage donné pour générer, à partir d'une information utile, une information codée avec une certaine redondance, et comprenant au moins une étape de poinçonnage appliquant un schéma de poinçonnage donné, et, après ladite étape de transmission sur ledit canal, une procédure de décodage, appliquant un schéma de décodage donné, pour obtenir, à partir d'une information à décoder, une estimation de ladite information utile en corrigeant des erreurs de transmission à l'aide de ladite certaine redondance, et comprenant au moins une étape de dépoinçonnage appliquant un schéma de dépoinçonnage donné, ledit procédé de transmission étant caractérisé en ce qu'il comprend en outre une étape d'observation des conditions de transmission pour déterminer au moins un paramètre caractéristique des conditions de transmission, une étape (2) de sélection de schéma de poinçonnage pour sélectionner en fonction dudit au moins un paramètre un schéma de poinçonnage de performance optimale parmi une pluralité de schémas de poinçonnage prédéterminés, une étape (12) de sélection de schéma de dépoinçonnage pour sélectionner en fonction dudit au moins un paramètre un schéma de dépoinçonnage correspondant audit schéma de poinçonnage de performance optimale parmi une pluralité de schémas de dépoinçonnage prédéterminés, le rendement global de ladite procédure de codage associée à ladite au moins une étape de poinçonnage étant un rendement constant.

2. Procédé de transmission numérique de type à codage correcteur d'erreurs selon la revendication 1, caractérisé en ce qu'un paramètre caractéristique des conditions de transmission peut être le taux d'erreurs binaires, le taux d'erreurs paquets, le rapport signal/bruit, le rapport signal sur interférence plus bruit, le nombre d'utilisateurs actifs d'un système de télécommunication, la qualité de service requise par le système de transmission, la vitesse de déplacement de l'utilisateur du système de transmission.

3. Procédé de transmission numérique de type à codage correcteur d'erreurs selon les revendications 1 ou 2, caractérisé en ce que, ladite procédure de codage comprenant une pluralité d'étapes de codage élémentaire associées en parallèle, chacune desdites étapes de codage élémentaire générant une information codée élémentaire, il comprend également une étape (3) d'adaptation de schéma de codage qui vérifie si ledit schéma de poinçonnage sélectionné par ladite étape (2) de sélection de schéma de poinçonnage conduit au poinçonnage intégral de l'information codée élémentaire d'une desdites étapes de codage élémentaire et qui, le cas échéant, modifie ledit schéma de codage de manière à ne plus avoir à utiliser ladite au moins une desdites étapes de codage élémentaire.

4. Procédé de transmission numérique de type à codage correcteur d'erreurs selon la revendication 3, caractérisé en ce que ladite procédure de codage applique un schéma de codage de type codage convolutif, lesdites étapes de codage élémentaire étant associées en parallèle et générant chacune une information codée élémentaire issue du produit de convolution d'une séquence constituée par ladite information utile et par un certain nombre d'informations auxiliaires, pouvant correspondre à des informations utiles précédentes, avec une réponse définie par un polynôme générateur.

5. Procédé de transmission numérique de type à codage correcteur d'erreurs selon la revendication 3, caractérisé en ce que ladite procédure de codage applique un schéma de codage de type turbo-codage, lesdites étapes de codage élémentaire étant concaténées en parallèle, en association avec des étapes d'entrelacement adaptées, une étape de poinçonnage intervenant après une étape de multiplexage associant les informations codées élémentaires desdites étapes de codage élémentaire.

6. Procédé de transmission numérique de type à codage correcteur d'erreurs selon la revendication 5, caractérisé en ce que ladite procédure de codage applique un schéma de codage de type turbo-codage à concaténation parallèle.

7. Procédé de transmission numérique du type à codage correcteur d'erreurs selon la revendication 5, caractérisé en ce que ladite procédure de codage applique un schéma de codage de type turbo-codage en bloc à concaténation parallèle.

8. Procédé de transmission numérique de type à codage correcteur d'erreurs selon l'une quelconque des revendications 3 à 7, caractérisé en ce que, ladite procédure de décodage comprenant une pluralité d'étapes de décodage élémentaire correspondant respectivement auxdites étapes de codage élémentaire, chacune desdites étapes de décodage élémentaire traitant une information à décoder correspondant à ladite information codée élémentaire de l'étape de codage élémentaire correspondante, il comprend également une étape (13) d'adaptation de schéma de décodage qui vérifie si ledit schéma de dépoinçonnage sélectionné par ladite étape (12) de sélection de schéma de dépoinçonnage indiqué qu'au moins une desdites étapes de décodage élémentaire correspond à une étape de codage élémentaire dont l'information codée élémentaire est intégralement poinçonnée et qui, le cas échéant, modifie ledit schéma de décodage de manière à ne plus avoir à utiliser ladite au moins une desdites étapes de décodage élémentaire.

9. Procédé de transmission numérique de type à codage correcteur d'erreurs selon l'une quelconque des revendications 3 à 7, caractérisé en ce que, ladite procédure de décodage reconstituant l'information utile à partir de n informations à décoder correspondant à n informations codées représentatives de l'information utile issues desdites étapes de codage élémentaire, il comprend également une étape (13) d'adaptation de schéma de décodage qui vérifie si ledit schéma de dépoinçonnage sélectionné par ladite étape (12) de sélection de schéma de dépoinçonnage indique qu'au moins une desdites informations codées a été intégralement poinçonnée et qui, le cas échéant, modifie ledit schéma de décodage de manière à ne plus tenir compte de l'information à décoder correspondant à ladite au moins une desdites informations codées.
